**Europäisches Patentamt**

(19) **European Patent Office**

(11) Veröffentlichungsnummer: **0 179 394**

**Office européen des brevets**

**B1**

(12) **EUROPÄISCHE PATENTSCHRIFT**

(45) Veröffentlichungstag der Patentschrift:
23.08.89

(51) Int. Cl.⁴: **H 03 J 7/18**

(21) Anmeldenummer: **85113152.4**

(22) Anmeldetag: **17.10.85**

(54) Verfahren zur Identifikation von Rundfunksendern und Rundfunkgerät hierfür.

(30) Priorität: **26.10.84 DE 3439264**

(43) Veröffentlichungstag der Anmeldung:
**30.04.86 Patentblatt 86/18**

(45) Bekanntmachung des Hinweises auf die Patenterteilung:
**23.08.89 Patentblatt 89/34**

(84) Benannte Vertragsstaaten:
**DE FR IT**

(56) Entgegenhaltungen:
**EP-A-0 092 055**
**EP-A-0 150 297**

**FUNKSCHAU, Nr. 5, März 1982, Seiten 53-56, München, DE; P. BAUER: "Mehr als ein Autoradio"**

(73) Patentinhaber: **Blaupunkt- Werke GmbH, Robert- Bosch- Strasse 200, D-3200 Hildesheim (DE)**

(72) Erfinder: **Strauss, Karl- Peter, Dipl.- Ing., Lachnerring 26, D-3200 Hildesheim (DE)**

(74) Vertreter: **Eilers, Norbert, Dipl.- Phys., Blaupunkt- Werke GmbH Robert- Bosch- Strasse 200, D-3200 Hildesheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Identifikation von mit einem Rundfunkempfänger, insbesondere Autoradio, empfangenen Rundfunksendern der im Oberbegriff des Anspruchs 1 angegebenen Gattung.

Ein solches Identifikationsverfahren dient der Bestimmung eines per Suchlauf oder per Tastenanwahl eingestellten Senders nach Sendeanstalt, Programm und Senderstandort. Der identifizierte Sender wird per Anzeige oder Sprachausgabe dem Hörenden zur Kenntnis gebracht und kann darüber hinaus zur Steuerung verschiedener Vorgänge verwendet werden. Ein solches Identifikationsverfahren ist deshalb erforderlich, da die Sendefrequenz von Sendern, die räumlich weit auseinander liegen und sich daher nicht stören, mehrfach belegt sind und somit die Bestimmung eines Senders nur anhand der Empfangsfrequenz nicht eindeutig ist.

Bei einem in der am 7. 8 85 veröffentlichten älteren Anmeldung EP-A-0 150 297 bereits vorgeschlagenen Verfahren der eingangs genannten Art werden als Prüfsender ein am momentanen Ort des Rundfunkgerätes empfangbarer Vergleichssender und alle mit diesem Vergleichssender frequenzgleichen Sender herangezogen. Nach der Überdeckungsprüfung werden alle diejenigen äquifrequenten Sender eliminiert, deren Empfangsgebiete sich mit keinem der Empfangsgebiete der Prüfsender überdecken. Verbleiben nach Elimination mehrere äquifrequente Sender, wird ein neuer empfangbarer Vergleichssender aufgesucht und die mit diesem frequenzgleichen Sender bestimmt. Die verbliebenen äquifrequenten Sender werden wiederum mit der neuen Gruppe von Prüfsendern auf Überdeckung geprüft und diejenigen verbliebenen äquifrequenten Sender eliminiert, bei welchen die Empfangsgebiete wiederum keine Überdeckung zeigen. Dieser Zyklus wird solange wiederholt, bis ein einziger äquifrequenter Sender übrigbleibt, der als der identifizierte Sender angezeigt wird.

Die erforderlichen Vergleichssender können dabei entweder per Suchlauf gefunden oder nach bestimmten Kriterien vorgegeben und dann eingestellt werden. Dabei ist die Schnelligkeit und damit die Effizienz des Identifikationsverfahrens jedoch sehr stark von der geschickten Wahl der Vergleichssender abhängig. Werden die Vergleichssender ungünstig bestimmt, so erfordert dieses Verfahren eine relativ lange Zeit bis zur Identifikation des empfangenen Senders. Um diese Verarbeitungszeit zu verkürzen, ist bereits vorgeschlagen worden, zur günstigen und gezielten Auswahl der Vergleichssender die Empfangsfeldstärken des zu identifizierenden Senders und der Vergleichssender zu messen und damit eine reduzierte fiktive Senderreichweite für die äquifrequenten Sender zu bestimmen. Damit erhöht sich die Zahl der pro Überdeckungsprüfungszyklus eliminierbaren äquifrequenten Sender, so daß weniger Prüfungsdurchgänge notwendig sind. Allerdings muß hierbei der Zusatzaufwand für die Feldstärkemessung in Kauf genommen werden.

Aus der Druckschrift Funkschau, Nr. 5, März 1982, Seiten 53 - 56, München, DE; P. Bauer: "Mehr als ein Autoradio" ist es bekannt, mit einem Autoradio anhand von Bereichskennungen aussendender Verkehrsfunksender einen empfangenen Sender zu identifizieren, auch wenn dieser kein Verkehrsfunksender ist.

Aus der Druckschrift EP-A-0 092 055 ist ein ortsveränderlicher Rundfunkempfänger mit einer Sendereinstellvorrichtung zum selbsttätigen Einstellen eines ein gewünschtes Senderprogramm abstrahlenden Senders bekannt. Eine Vergleichs- und Auswahlvorrichtung läßt nur Sender zum Vergleich zu, deren räumliche Entfernung von dem momentan eingestellten Sender einen vorgegebenen Maximalwert nicht überschreitet. Die Entfernung zwischen zwei Sendern wird dabei mittels einer Recheneinheit aus den abgespeicherten Koordinaten der Senderstandorte bestimmt.

Der Erfindung liegt die Aufgabe zugrunde, ein Identifikationsverfahren der eingangs genannten Art derart zu verbessern, daß damit relativ schnell, also nach kurzer Verarbeitungszeit, eine weitgehend sichere Identifikations des empfangen Senders möglich ist und dabei außer den notwendigen Speicherdaten für alle im Aktionsradius des Rundfunkempfängers vorhandenen Rundfunksender keine zusäzlichen Meßdaten, wie etwa die Empfangsfeldstärke, benötigt werden. Außerdem soll ein Runfunkgerät angegeben werden, in welcher dieses Verfahren vorteilhaft realisiert ist.

Die Aufgabe ist bei einem Verfahren der im Oberbegriff des Anspruchs 1 angegebenen Gattung erfindungsgemäß durch die Merkmale im Kennzeichenteil des Anspruchs 1 gelöst.

Das erfindungsgemäße Verfahren hat den Vorteil, daß es nur solche Informationen über vorhandene Sender benötigt, die in käuflichen, von der Post vertriebenen Senderlisten enthalten sind. Diese Informationen können ohne zusätzliche Aufbereitung und insbesondere ohne besondere Zuordnung durch Übertragen in einen Festwertspeicher abgespeichert werden. Dies wiederum bietet den Vorteil, daß Änderungen und Ergänzungen dieser Senderinformationen ohne weiteres in den im Rundfunkgerät integrierten Festwertspeicher eingegeben werden können. Das Verfahren ist ein statistisches Verfahren und berücksichtigt alle vorhandenen Sender mit entsprechender Wichtung.

Eine vorteilhafte Weiterbildung des erfindungsgemäßen Verfahrens ergibt sich aus Anspruch 2. Durch die Auswertung bereits erfolgter Identifikation von am Ort des Rundfunkgeräts einmal empfangenen Sendern wird nicht nur eine große Signifikanz der Wichtungen erzielt, sondern auch gleichzeitig andere Informationen, wie z. B. die ARI-Kennung, zur sicheren Identifikation des empfangenen Senders ausgenutzt.

Weitere vorteilhafte Ausbildungen des erfindungsgemäßen Verfahrens ergeben sich aus den weiteren Ansprüchen 3 - 10.

Eine vorteilhafte Vorrichtung zur Realisierung des erfindungsgemäßen Verfahrens in einem Rundfunkgerät, insbesondere in einem Autoradio, ergibt sich aus Anspruch 11, insbesondere in Verbindung mit einem oder mehreren der Ansprüche 12 - 16.

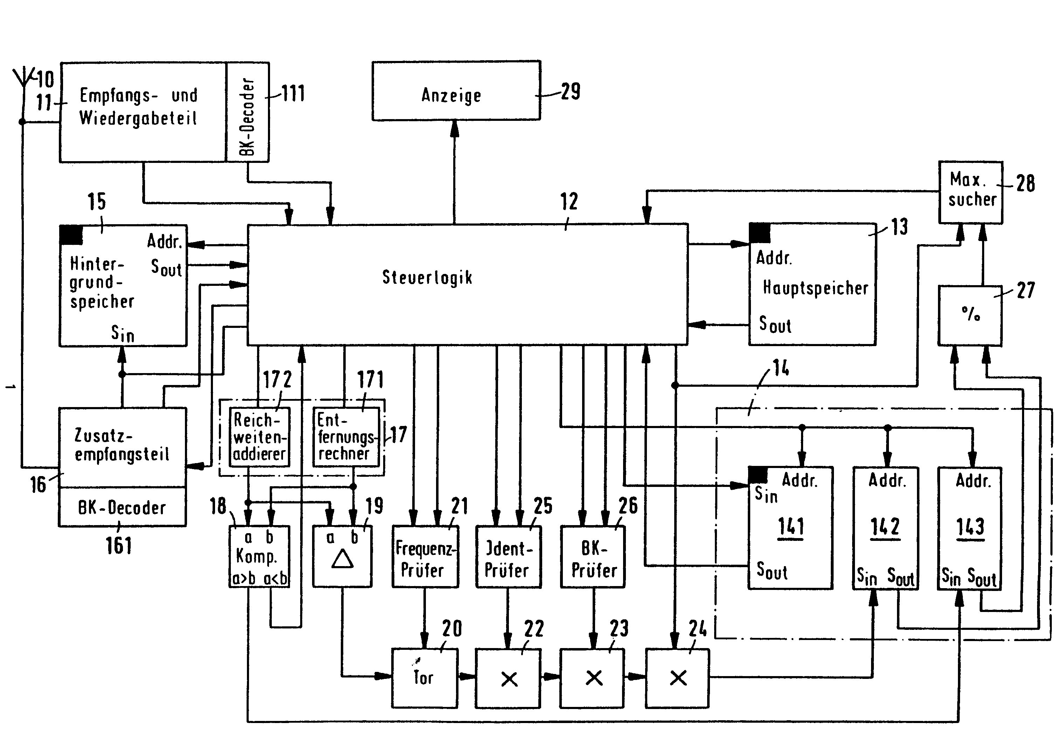

Die Erfindung ist anhand eines in der Zeichnung dargestellten Ausführungsbeispiels eines Rundfunkgeräts

2

mit einer Vorrichtung zum Durchführen des erfindungsgemäßen Senderidentifikationsverfahrens im folgenden näher beschrieben. Die Zeichnung zeigt ein Blockschaltbild eines Autoradios in Verbindung mit einer Vorrichtung zur Senderidentifikation.

Das in der Zeichnung schematisch angedeutete Autoradio weist einen mit einer Antenne 10 verbundenen Empfangs- und Wiedergabeteil 11 auf, in welchem üblicherweise zur Einstellung eines gewünschten Senders eine Sendervorwahleinrichtung und eine Sendereinstellautomatik integriert ist. Die Sendervorwahleinrichtung weist üblicherweise ein Tastenfeld zur Vorwahl von angezeigten oder fest eingestellten Sendern und eine Auslösetaste für den Sendersuchlauf auf. Die Sendervorwahleinrichtung und die Sendereinstellautomatik werden von einer Steuerlogik 12 gesteuert, die auch sämtliche Steuerfunktionen der Vorrichtung zur Senderidentifikation ausführt und im allgemeinen von einem Mikroprozessor gebildet wird.

Zur Senderidentifikationsvorrichtung gehören ferner ein Hauptspeicher 13, ein Zwischenspeicher 14, ein Zusatzempfangsteil 16 und weitere Bauelemente, auf die im einzelnen noch nachfolgend weiter eingegangen wird. Der Hauptspeicher 13 ist als Lesespeicher ausgebildet und enthält abgespeichert alle im möglichen Aktionsradius des Autoradios vorhandenen Sender mit ihren Sendefrequenzen, Senderstandorten, Senderreichweiten, abgestrahlten Programmen, Sendeanstalten und ggf. Bereichskennung (BK) von sog. ARI-Sendern. Die Senderstandorte sind dabei durch Standortkoordinaten gekennzeichnet, die entweder in Längen- und Breitengraden angegeben oder nach einem speziellen Koordinatensystem festgelegt sind. Der Zwischenspeicher 14 und der Hintergrundspeicher 15 sind als Schreib-Lese-Speicher (RAM) ausgebildet. Der Zwischenspeicher 14 dient zum Zwischenspeichern von Kennzeichen, die bestimmte aus dem Hauptspeicher 13 ausgelesene Sender individualisieren. Ein solches individualisierendes Kennzeichen ist z. B. die Adresse des Hauptspeichers, unter welcher der Sender im Hauptspeicher 13 aufgefunden werden kann. Jedem Speicherplatz zur Aufnahme eines individualisierenden Kennzeichens ist unter der gleichen Adresse im Zwischenspeicher 14 ein erster Speicherplatz für eine Summe noch zu erläuternder Bewertungszahlen und ein zweiter Speicherplatz für die Anzahl der noch zu erläuternden Überdeckungen zugeordnet. Im Zwischenspeicher 14 sind die Speicherplätze zum Ablegen der individualisierenden Kennzeichen mit 141, die ersten Speicherplätze für die Bewertungszahl mit 142 und die zweiten Speicherplätze für die Anzahl der Überdeckungen mit 143 bezeichnet. Im Hintergrundspeicher 15 sind die Frequenzen aller am momentanen Standort des Autoradios empfangbaren Sender kodiert abgespeichert. Der Inhalt des Hintergrundspeichers 15 wird laufend aktualisiert, wozu der Zusatzempfangsteil 16 laufend durchgestimmt wird und die empfangbaren Sender detektiert. Zweckmäßigerweise liest dabei die Steuerlogik 12 fortlaufend die abgespeicherten Sendefrequenzen aus dem Hauptspeicher 13 aus und führt sie dem Zusatzempfangsteil 16 als Einstellfrequenz zu. Detektiert der Zusatzempfangsteil 16 Empfang, so wird die ausgelesene Sendefrequenz über die Steuerlogik 12 unter fortlaufender Adresse im Hintergrundspeicher 15 abgelegt.

Zur Senderidentifikationsvorrichtung gehört weiter eine Recheneinheit 17 mit einem Entfernungsrechner 171 und einem Reichweitenaddierer 172. Der Entfernungsrechner 171 bestimmt aus den Standortkoordinaten zweier Senderstandorte deren Entfernung, und der Reichweitenaddierer 172 addiert die Reichweiten der den beiden Senderstandorten zugeordneten Sender, wobei alle diese Angaben der Recheneinheit 17 über die Steuerlogik 12 aus dem Hauptspeicher 13 zugeführt werden. Die Ausgänge von Entfernungsrechner 171 und Reichweitenaddierer 172 sind einerseits mit einem Komparator 18 und andererseits mit einem Subtrahierer 19 verbunden. Der Komparator gibt an seinem einen Ausgang ein logisch 1-Signal aus, wenn die Summe der Reichweiten größer ist als die Entfernung der zugeordneten Senderstandorte voneinander, wodurch eine vorliegende Überdeckung der Empfangsgebiete zweier Sender charakterisiert ist. Der Subtrahierer 19 gibt an seinem Ausgang ein den Überdeckungsgrad der beiden Empfangsgebiete kennzeichnendes Ausgangsdatum aus, das im folgenden als Bewertungszahl bezeichnet wird. Die Bewertungszahl ist dabei umso größer, je weiter sich die Empfangsgebiete zweier Sender überdecken, also je größer die Differenz zwischen der Summe der Senderreichweiten und der Entfernung der Senderstandorte ist. Die am Ausgang des Komparators 18 für eine vorliegende Überdeckung anstehende Wertigkeit wird in die Speicherplätze 143 des Zwischenspeichers 14 und die am Ausgang des Subtrahierers 19 anstehende Bewertungszahl wird in die Speicherplätze 142 des Zwischenspeichers 14 eingeschrieben. Zwischen dem Ausgang des Subtrahierers 19 und dem Zwischenspeicher 14 sind noch ein Tor 20, das von einem Frequenzprüfer 21 gesteuert wird, und drei Multiplizierer 22, 23 und 24 eingeschaltet. Während der Multiplizierer 22 einen einstellbaren Multiplikationsfaktor aufweist, der normalerweise 1 ist und von einem Identitätsprüfer 25 einerseits auf einen Wert, der größer ist als 1, und andererseits auf -1 verändert werden kann, werden den Multiplizierern 23 und 24 je nach Ansteuerung durch einen BK-Prüfer 26 bzw. durch die Steuerlogik 12 ein zwei unterschiedliche Werte annehmender Multiplikationsfaktor zugeführt. Durch diese Multiplizierer 22 - 24 wird eine Wichtung der am Ausgang des Subtrahierers 19 anstehenden Bewertungszahl vor dem Einschreiben in die Speicherplätze 142 vorgenommen und zwar nach noch näher zu beschreibenden Kriterien. Der Zwischenspeicher 14 ist derart ausgebildet, daß in den Speicherplätzen 142 und 143 nicht wie üblich der Speicherinhalt überschrieben wird, sondern daß jeweils eine Addition des aktuellen Eingangsdatums mit dem Speicherplatzinhalt erfolgt. Der Datenausgang des die Speicherplätze 142 umfassenden Teilspeichers und der Datenausgang des die Speicherplätze 143 umfassenden Teilspeichers sind mit den beiden Eingängen eines Dividierers 27 verbunden, dessen Ausgang mit dem einen Eingang eines Maximumsuchers 28 verbunden ist. Der andere Eingang des Maximumsuchers 28 ist mit dem Ausgang des die Speicherplätze 141 umfassenden Teilspeichers des Zwischenspeichers 14 verbunden. Der Ausgang des Maximumsuchers 28 ist der Steuerlogik 12 zugeführt. Die Steuerlogik 12 steuert eine Anzeige 29, in welcher nach erfolgter Identifikation der identifizierte Sender mit Sendeanstalt, Programm, Senderstandort und evtl. Sendefrequenz angezeigt wird. Zweckmäßigerweise werden alle von der Recheneinheit 17, dem Komparator 19, dem Subtrahierer 19, dem Tor 20, den Multiplizierern 22 - 24, den Frequenz-, Identität- und BK-Prüfern 21, 25, 26, dem Dividierer 27 und dem Maximumsucher 28 durchzuführenden Funktionen von dem auch die Funktion der Steuerlogik 12 ausführenden Mikroprozessor durchgeführt. Der Zusatzempfangsteil 16 kann auch einen BK-Decoder 161 aufweisen, in welchem die Bereichskennung (BK) eines sog. ARI-Senders erkannt werden kann. Voraussetzung für diesen BK-Dekoder 161 ist ein Rundfunkgerät, mit welchem automatisch die ARI-Sender eingestellt werden können, wozu das Empfangs- und Wiedergabeteil 11 einen gleichen BK-Decoder 111 aufweisen muß.

Mit einer solchen in das Autoradio integrierten Vorrichtung zur Senderidentifikation wird das Verfahren zur Identifikation eines empfangenen Senders wie folgt durchgeführt:

In dem Hauptspeicher 13 ist eine komplette Tabelle aller Sender der Bundesrepublik mit ca. 600 Sendern kodiert abgespeichert. Der Hintergrundspeicher 15 enthält alle Frequenzen der am momentanen Empfangsort des Autoradios empfangbaren Sender. Für ein im Ort Hildesheim stehendes Autoradio wären dies die in MHz angegebenen Frequenzen 88,95; 89,95; 89 5; 89,9; 90,6; 90,9; 91,55; 92,1; 93,0; 93,2; 94,6; 95,5; 96,2; 97,4; 97,6; 98,0; 98,7; 99,0. Im Empfangs- und Wiedergabeteil 11 wird ein Sender mit der Empfangsfrequenz 89,9 MHz empfangen. Dieser Sender wird nun wie folgt identifiziert:

Aus dem Hauptspeicher 13 werden alle Sender aufgesucht, deren Sendefrequenz der Empfangsfrequenz 89, 9 MHz entspricht. Diese sog. äquifrequenten Sender werden in den Speicherplätzen 141 des Teilspeichers im Zwischenspeicher 14 eingeschrieben. Dies sind NDR 3 (Harz), NDR 3 (Bungsberg) und SWF 3 (Donnersberg). Da die Sender im Hauptspeicher mit allen ihren Senderdaten unter einer bestimmten Adresse abrufbar sind, genügt das Einschreiben der Adressen, in welchem diese Sender im Hauptspeicher auffindbar sind, in den Zwischenspeicher 14.

Nun werden alle im Zwischenspeicher 14 enthaltenen äquifrequenten Sender mit den im Hauptspeicher 13 abgelegten Sendern, mit Ausnahme der im Zwischenspeicher befindlichen äquifrequenten Sender, auf Überdeckung ihrer Empfangsgebiete geprüft. Diese im Hauptspeicher 13 abgelegten Sender - mit Ausnahme der im Zwischenspeicher vorübergehend abgespeicherten äquifrequenten Sender - werden im folgenden als Prüfsender bezeichnet.

Aus dem Zwischenspeicher 14 wird zunächst der erste äquifrequente Sender, im Beispiel NDR 3 (Harz), ausgelesen und bezüglich seines Senderstandortes mit allen Prüfsendern in dem Hauptspeicher 13 verglichen. Dabei wird zunächst der Abstand zwischen dem Senderstandort des NDR 3 (Harz) und dem jeweiligen Prüfsender aus dem Hauptspeicher 13 berechnet (Entfernungsrechner 171).

Dann werden die Senderreichweiten der beiden Sender addiert (Reichweitenaddierer 172). Ist die Summe der Reichweiten kleiner als die Standortentfernung (Komparator 18) wird der Prüfvorgang abgebrochen und der nächste Prüfsender aus dem Hauptspeicher 13 ausgelesen. Ist die Summe der Reichweiten größer als die Standortentfernung (Komparator 18) wird der dem äquifrequenten Sender NDR 3 (Harz) zugeordnete Speicherplatz 143 im dritten Teilspeicher um 1 erhöht. Dann wird geprüft, ob die Frequenz des Prüfsenders, der dem Überdeckungskriterium genügt, im Hintergrundspeicher 15 enthalten ist, was bedeutet, daß er am momentanen Standort des Autoradios empfangbar ist. Ist dies nicht der Fall, so wird der Prüfvorgang abgebrochen und der nächste Prüfsender aus dem Hauptspeicher 13 ausgelesen. Ist die Sendefrequenz des Prüfsenders im Hintergrundspeicher 15 enthalten (Frequenzprüfer 21 zeigt Koinzidenz und steuert das Tor 20 auf) so wird der aus der Differenz von Reichweitensumme und Standortentfernung ermittelte Überdeckungsgrad der Empfangsgebiete der beiden Sender (Subtrahierer 19, hier Bewertungszahl) in den dem äquifrequenten Sender NDR 3 (Harz) zugeordneten Speicherplatz 142 im zweiten Teilspeicher des Zwischenspeichers 14 eingeschrieben, und zwar in der Weise, daß ein dort bereits vorhandener Speicherinhalt um den Betrag der Bewertungszahl erhöht wird. Nach Abprüfung des Senders NRD 3 (Harz) mit allen ca. 600 Sendern im Hauptspeicher 13 haben sich im Beispiel 15 Überdeckungen ergeben, so daß in dem dem Sender NDR 3 (Harz) zugeordneten Speicherplatz 143 die Zahl 15 steht. Wie im einzelnen nicht nachgewiesen zu werden braucht, hat die Aufsummierung der Bewertungszahlen der empfangbaren Prüfsender in dem den Sender NDR 3 (Harz) zugeordneten Speicherplatz 142 die Summe 2560 ergeben. Nunmehr wird der zweite äquifrequente Sender NDR 3 (Bungsberg) mit seinen Standortkoordinaten ausgelesen und mit allen Prüfsendern aus dem Hauptspeicher 13 auf Überdeckung und Empfangbarkeit abgeprüft. Der gleiche Prüfungszyklus wird anschließend mit dem dritten äquifrequenten Sender SWF 3 (Donnersberg) durchgeführt. Danach zeigt der Zwischenspeicher 14 folgenden Speicherinhalt:

| Adresse | Speicherplatz | | |
|---|---|---|---|
| | 141 | 142 | 143 |
| 1 | NDR 3 (Harz) | 2 560 | 15 |
| 2 | NDR 3 (Bungsberg) | 450 | 12 |
| 3 | SWF 3 (Donnersberg) | 1036 | 43 |

Nunmehr wird durch Normierung der den einzelnen äquifrequenten Sendern zugeordneten Summen der Bewertungszahlen das Bewertungsmaß für die einzelnen äquifrequenten Sender gebildet. Hierzu wird die Summe der Bewertungszahlen durch die Anzahl der Überdeckungen dividiert, also letztlich der Speicherinhalt des Speicherplatzes 142 durch den Speicherinhalt des Speicherplatzes 143 (Dividierer 27). Im Beispiel ergeben

4

sich für die äquifrequenten Sender folgende Bewertungsmaße:

NDR 3 (Harz)          171
NDR 3 (Bungsberg)
                            38
SWF 3 (Donnersberg)     24

Von den Bewertungsmaßen wird nunmehr das signifikant größte herausgesuchte (Maximumsucher 28) und der zugeordnete Sender als der Empfangssender identifiziert. Im Beispiel ist dies der Sender NDR 3 (Harz). In der Anzeige 29 wird dieser Sender mit Sende anstalt NDR Programm 3, Standort Harz und Sendefrequenz 89,9 MHz ausgegeben. Zugleich wird im Hintergrundspeicher 15 ein die festgestellte Identität des Senders mit der Empfangsfrequenz 89,9 MHz kennzeichnender Kode, z. B. NDR 3 (Harz), in Zuordnung zu der dort abgespeicherten Sendefrequenz 89,9 MHz abgespeichert.

Unabhängig davon ob ein momentan empfangener Sender identifiziert werden soll oder nicht kann das vorstehend beschriebene Verfahren auf alle am momentanen Ort des Autoradios empfangbaren Sender, also auf diejenigen Sender, deren Sendefrequenz im Hintergrundspeicher 15 abgelegt sind, mehrfach angewandt werden. Der identifizierte Sender wird dann nicht in der Anzeige 29 ausgegeben, sondern nur im Hintergrundspeicher 15 als identifiziert gekennzeichnet. Diese Kennzeichnung "identifiziert" erfolgt durch Einschreiben eines Indentitätskodes in den Hintergrundspeicher 15, und zwar in Zuordnung zu derjenigen dort abgespeicherten Sendefrequenz, deren zugehörige Sender identifiziert worden ist. Ein solcher Identitätskode kann z. B. die Sendeanstalt und die Programmnummer des identifizierten Senders und dessen Senderstandort enthalten.

Die Ergebnisse bereits erfolgter Identifikationen werden nunmehr dazu ausgenutzt, das beschriebene Senderidentifikationsverfahren hinsichtlich der vorgenommenen Wichtung der Bewertungszahlen zu verbessern. Ist bei dem Senderidentifikationsverfahren für einen Prüfsender eine Bewertungszahl ermittelt, so wird die im Hauptspeicher 13 fest abgespeicherte Senderidentität des aktuellen und empfangbaren Prüfsenders, die z. B. durch den Namen der Sendeanstalt und die Nummer des abgestrahlten Programms gegeben sein kann (SWF 3), mit dem im Hintergrundspeicher 15 abgespeicherten Identitätskode - und zwar in Zuordnung zu der Sendefrequenz - des aktuellen Prüfsenders verglichen (Identitätsprüfer 25). Je nach Ergebnis des Vergleiches wird die errechnete Bewertungszahl vor Einschreiben in den Zwischenspeicher 14, und dort in Zuordnung zu dem aktuellen äquifrequenten Sender, unterschiedlich gewichtet. Bei Übereinstimmung von Identitätskode und Senderidentität des aktuellen Prüfsenders wird die Bewertungszahl vergrößert, und zwar durch Multiplikation mit einem Faktor, der größer als 1 ist (Multiplizierer 22). Stimmen Identitätskode und Senderidentität des aktuellen Prüfsenders nicht überein, so wird die Bewertungszahl negativ gesetzt (der Multiplikationsfaktor des Multiplizierers 22 wird auf -1 eingestellt), so daß diese negative Bewertungszahl beim Einschreiben in den Zwischenspeicher 14 von der dort bereits abgespeicherten Summe der Bewertungszahlen abgezogen wird. Ist im Hintergrundspeicher 15 für den aktuellen Prüfsender kein Identitätskode abgespeichert, wurde der aktuelle Prüfsender also bislang noch nicht identifiziert, so behält die Bewertungszahl ihren errechneten Wert (der Multiplikationsfaktor des Multiplizierers 22 beträgt 1).

In einer Erweiterung des beschriebenen Senderidentifikationsverfahrens kann auch die von sog. ARI-Sendern (Sender mit Autofahrer-Rundfunkinformation) abgestrahlte Bereichskennung (BK) zur Verbesserung der Erkennungswahrscheinlichkeit des zu identifizierenden Senders herangezogen werden. In diesem Fall sind in dem Hauptspeicher 13 auch zu allen abgespeicherten Sendern, die sog. ARI-Sender sind, die zugeordnete BK abgespeichert. Die BK eines empfangenen Senders wird von dem BK-Dekoder 111 des Empfangs- und Wiedergabeteils 11 des Autoradios erkannt. Weiterhin hat der Zusatzempfangsteils 16 ebenfalls einen BK-Dekoder 116, der zu allen am momentanen Ort des Autoradios empfangbaren Sendern die zugehörige BK ermittelt, sofern eine solche vorhanden ist. Diese BK wird in Zuordnung zu den Sendefrequenzen im Hintergrundspeicher 15 eingeschrieben.

Das vorstehend beschriebene Verfahren zur Senderidentifikation wird nun dahingehend modifiziert, daß bei der Auswahl der mit dem zu identifizierenden Sender frequenzgleichen Sender aus dem Hauptspeicher 13, also bei der Bestimmung der äquifrequenten Sender, dann im Falle der Detektion einer BK des zu identifizierenden Senders nur solche äquifrequenten Sender zugelassen werden, deren BK mit der detektierten BK des zu identifizierenden Senders übereinstimmen, und im Falle der Nichtdetektion einer BK für den zu identifizierenden Sender nur solche äquifrequenten Sender zugelassen werden, die ebenfalls keine BK aufweisen.

Zusätzlich wird mit Hilfe der Bereichskennung von sog. ARI-Sendern auch die Wichtung der Bewertungszahlen verbessert. Hierzu wird geprüft, ob die im Hauptspeicher 13 dem aktuellen Prüfsender zugeordnete BK mit der im Hintergrundspeicher 15 in Zuordnung zu der Sendefrequenz des Prüfsenders ggf. abgespeicherte BK übereinstimmt (BK-Prüfer 26). Ist dies der Fall, so wird die mit diesem Prüfsender errechnete Bewertungszahl für den äquifrequenten Sender zusätzlich vergrößert (Multiplikationsfaktor des Multiplizierers 23 wird größer als 1 eingestellt). Stimmen die zu vergleichenden BK nicht überein, sei es daß im Hintergrundspeicher 15 keine oder eine falsche BK abgespeichert ist, so wird die Bewertungszahl nicht verändert (Multiplikationsfaktor des Multiplizierers 23 beträgt 1).

Zur weiteren Verbesserung der Wichtung der Bewertungszahlen wird zusätzlich geprüft, ob die Paarung aus im Hintergrundspeicher 15 enthaltener Sendefrequenz und BK eines aktuellen Prüfsenders in dem Hauptspeicher 13 eindeutig, d.h. nur einmal vorhanden ist. Ergibt diese Prüfung, daß diese Sendefrequenz/BK-Paarung im Hauptspeicher 13 nur für einen einzigen Sender abgespeichert ist, also Eindeutigkeit vorliegt, so wird die mit diesem Prüfsender ermittelte Bewertungszahl abermals erhöht (Multiplikationsfaktor des Multiplizierers 24 wird größer als 1 eingestellt). Ergibt sich bei dieser Prüfung eine Mehrdeutigkeit, so wird die Bewertungszahl nicht verändert (Multiplikationsfaktor des Multiplizierers 24 beträgt 1).

Im übrigen wird das Senderidentifikationsverfahren in allen Einzelheiten so durchgeführt wie eingangs beschrieben.

**Patentansprüche**

1. Verfahren zur Identifikation von mit einem Rundfunkempfänger, insbesondere Autoradio, empfangenen Rundfunksendern, unter Zuhilfenahme der zugehörigen Empfangsfrequenzen und von fest abgespeicherten Informationen über Senderidentität, Sendefrequenz, Senderstandort und Senderreichweite aller im möglichen Aktionsradius des Rundfunkempfängers befindlicher Sender, wobei zum Selektieren von Sendern mit höherer Empfangswahrscheinlichkeit die Empfangsgebiete von denjenigen Sendern, deren Sendefrequenz mit der Empfangsfrequenz übereinstimmen, äquifrequenter Sender, auf Überdeckung mit Empfangsgebieten von Prüfsendern geprüft werden, dadurch gekennzeichnet, daß als Prüfsender alle abgespeicherten Sender genommen werden und daß für jeden äquifrequenten Sender die Anzahl der Überdeckungen festgestellt wird, daß jeder Prüfsender, für welchen eine Überdeckung festgestellt worden ist, auf Empfangbarkeit am momentanen Standort des Rundfunkempfängers geprüft wird, daß bei Empfangbarkeit des Prüfsenders dem mit ihm bei der Überdeckungsprüfung gepaarten äquifrequenten Sender eine dem Überdeckungsgrad der beiden Empfangsgebiete proportionale Bewertungszahl zugeordnet wird, daß alle jeweils einem äquifrequenten Sender zugeordnete Bewertungszahlen addiert werden und die Summe normiert, d. h. durch die Anzahl der für den äquifrequenten Sender festgestellten Überdeckungen dividiert, und aus dem Quotienten ein Bewertungsmaß des äquifrequenten Senders abgeleitet wird und daß derjenige äquifrequente Sender, dessen Bewertungsmaß signifikant größer ist als die Bewertungsmaße der übrigen äquifrequenten Sender, als identifizierter Sender angegeben wird.

2. Verfahren nach Anspruch 1, dadurch gekennzeichnet, daß für einen bereits identifizierten Sender ein seine festgestellte Identität kennzeichnender Code, Identitätscode, in Zuordnung zu seiner Sendefrequenz vorübergehend abgespeichert wird und daß die Bewertungszahl für den äquifrequenten Sender verändert wird, wenn für den aktuellen Prüfsender ein solcher Identitätscode abgespeichert ist.

3. Verfahren nach einem der Ansprüche 1 bis 2, dadurch gekennzeichnet, daß eine Überdeckung der Empfangsgebiete von äquifrequenten Sender und Prüfsender dann festgestellt wird, wenn die Summe der Senderreichweiten größer ist als die Entfernung zwischen den Standorten der beiden Sender.

4. Verfahren nach einem der Ansprüche 1 bis 3, dadurch gekennzeichnet, daß der Überdeckungsgrad zweier Empfangsgebiete durch Subtraktion der Entfernung zwischen den Standorten von der Summe der Senderreichweiten der zugehörigen Sender berechnet wird.

5. Verfahren nach einem der Ansprüche 1 bis 4, bei welchem als zusätzliche Information von Rundfunksendern mit Autofahrerrundfunkinformation, ARI-Sendern, deren Bereichskennung (BK) fest abgespeichert wird und bei welchem die Bereichskennung eines empfangenen ARI-Senders detektiert wird, dadurch gekennzeichnet, daß bei BK-Detektion nur solche äquifrequenten Sender, deren Bereichskennung mit der detektierten Bereichskennung übereinstimmen, und bei fehlender BK-Detektion nur äquitrequente Sender ohne Bereichskennung zugelassen werden.

6. Verfahren nach Anspruch 5, dadurch gekennzeichnet, daß bei der Prüfung der Empfangbarkeit des aktuellen Prüfsenders, dessen Bereichskennung bestimmt und die Bewertungszahl des mit ihm bei der Überdeckungsprüfung gepaarten äquifrequenten Senders erhöht wird, wenn die bestimmte Bereichskennung mit der fest abgespeicherten Bereichskennung des aktuellen Prüfsenders übereinstimmt.

7. Vorrichtung zur Durchführung des Verfahrens nach einem der Ansprüche 1 bis 6, mit einem Hauptspeicher (13), in welchem alle im möglichen Aktionsradius des Rundfunkempfängers vorhandenen Sender mit Senderidentität, Sendefrequenz, Senderstandort und Senderreichweite codiert abgelegt sind, mit einem als Schreib-Lese-Speicher ausgebildeten Zwischenspeicher (14) zum Einschreiben zumindest von die äquifrequenten Sender individualisierenden Kennzeichen, mit einer Recheneinheit (17) zum Bestimmen der Entfernung zwischen zwei Senderstandorten einerseits und zur Addition der Senderreichweiten der zugeordneten Sender andererseits, mit einer Vergleichseinheit (18), welche ein die Überdeckung kennzeichnendes Ausgangsdatum ausgibt und mit einem Subtrahierer (19), welcher den Grad der Überdeckung ermittelt, dadurch gekennzeichnet,

daß in dem Zwischenspeicher (14) jedem einen äquifrequenten Sender individualisierenden Kennzeichen ein erster Speicherplatz (142) für die Summe der Bewertungszahlen und ein zweiter Speicherplatz für die Anzahl der Überdeckungen zugeordnet ist, daß ein als Schreib-Lese-Speicher ausgebildeter Hintergrundspeicher (15) vorgesehen ist, in welchem zumindest die Frequenzen aller am momentanen Standort des Rundfunkempfängers empfangbaren Sender codiert abgespeichert sind, daß der Recheneinheit (17) ein Bewertungszahlrechner, vorzugsweise Subtrahierer (19), nachgeschaltet ist, an dessen Ausgang ein den Überdeckungsgrad zweier Empfangsgebiete kennzeichnendes Ausgangsdatum ansteht, daß die Ausgänge von Vergleichsschaltung (18) und Bewertungszahlrechner (19) in der Weise mit dem Zwischenspeicher (14) verbunden sind, daß in jedem der ersten und zweiten Speicherplätze (142, 143) eine Addition des aktuellen Eingangsdatums mit dem Speicherplatzinhalt erfolgt, daß zwischen dem Bewertungszahlrechner (19) und dem Zwischenspeicher (14) eine Torschaltung (20) eingeschaltet ist, welche das Ausgangsdatum des Bewertungszahlrechners (19) nur dann als Eingangsdatum auf den Zwischenspeicher (14) durchschaltet, wenn die Frequenz des aktuellen Prüfsenders in dem Hintergrundspeicher (15) enthalten ist, daß dem Zwischenspeicher (14) ein Bewertungsmaßrechner (27) nachgeschaltet ist, dem der Speicherinhalt des ersten und zugeordneten zweiten Speicherplatzes (142, 143) getrennt zugeführt ist und daß dem Bewertungsmaßrechner (27) ein Maximumsucher (28) nachgeschaltet ist, der das individualisierende Kennzeichen desjenigen äquifrequenten Senders, welchem das größte Bewertungsmaß zugehörig ist, als Identifikationsmerkmal für den identifizierten Sender ausgibt.

8. Vorrichtung nach Anspruch 7, dadurch gekennzeichnet,

daß der Bewertungsmaßrechner einen Dividierer (27) aufweist, der das Ausgangsdatum des ersten Speicherplatzes (142) durch das Ausgangsdatum des zweiten Speicherplatzes (143) dividiert.

9. Vorrichtung nach Anspruch 7 oder 8, dadurch gekennzeichnet,

daß im Hintergrundspeicher (15) jeder abgespeicherten Frequenz eines empfangbaren Prüfsenders ein Speicherplatz zum Abspeichern eines dem Prüfsender zugehörigen Identitätscodes zugeordnet ist, daß zwischen Torschaltung (20) und Zwischenspeicher (14) ein Multiplizierer (22) eingeschaltet ist, der das die Torschaltung (20) passierende Ausgangsdatum des Bewertungszahlrechners (19) mit einem Faktor multipliziert, der üblicherweise 1 ist und von einem Identifikationsprüfer (25) veränderbar ist, und daß der Identifikationsprüfer (25) derart ausgebildet ist, daß er für jeden empfangbaren Prüfsender den aus dem Hintergrundspeicher (15) ausgelesenen Identitätscode mit der aus dem Hauptspeicher (13) ausgelesenen Senderidentität vergleicht und bei Koinzidenz ein den Multiplikationsfaktor des Multiplizierers (22) vergrößerndes, vorzugsweise verdoppelndes, und bei Nichtinkoinzidenz ein den Multiplikationsfaktor des Multiplizierers (22) verkleinerndes, vorzugsweise invertierendes, Steuersignal generiert.

10. Vorrichtung nach einem der Ansprüche 7 bis 9, gekennzeichnet durch einen Zusatzempfangsteil (16), der laufend alle Prüfsender auf Empfangbarkeit am momentanen Standort des Rundfunkempfängers prüft, und durch eine Steuerlogik (12), die bei Empfangbarkeit des Prüfsenders das Einschreiben der zugehörigen Sendefrequenz in den Hintergrundspeicher (15) auslöst.

## Claims

1. Method of identifying radio stations received by a radio receiver, in particular a car radio, using the associated reception frequencies and permanently-stored information on station identity, broadcasting frequency, station location and broadcasting range of all stations in the possible radius of action of the radio receiver, in which method, for the selecting of stations with higher reception probability, the reception areas of those stations of which the broadcasting frequency matches the reception frequency, equifrequent stations, are tested for coincidence with reception areas of test stations, characterized in that all stored stations are taken as test stations and in that, for each equifrequent station, the number of coincidences is established, in that each test station for which a coincidence has been established is tested for receivability at the momentary location of the radio receiver, in that, if the test station can be received, an assessment number proportional to the degree of coincidence of the two reception areas is assigned to the equifrequent station paired with the said test station in the coincidence test, in that all assessment numbers assigned respectively to an equifrequent station are added and the sum is scaled, i.e. divided by the number of coincidences established for the equifrequent station, and a measure of assessment of the equifrequent station is derived from the quotient, and in that the equifrequent station of which the measure of assessment is significantly greater than the measures of assessment of the other equifrequent stations is specified as identified station.

2. Method according to claim 1, characterized in that, for an already identified station, a code characterizing its established identity, identity code, is temporarily stored in assignment with its broadcasting frequency, and in that the assessment number for the equifrequent station is changed whenever such an identity code has been stored for the current test station.

3. Method according to one of claims 1 to 2, characterized in that a coincidence of the reception areas of equifrequent station and test station is established whenever the sum of the station ranges is greater than the distance between the locations of the two stations.

4. Method according to one of claims 1 to 3, characterized in that the degree of coincidence of two reception areas is calculated by subtraction of the distance between the locations from the sum of the station ranges of the associated stations.

5. Method according to one of claims 1 to 4, in which, as additional information, from radio stations with car driver radio information, ARI stations, their service identification (BK) is permanently stored, and in which the service identification of a received ARI station is detected, characterized in that, in the case of BK detection, only those equifrequent stations whose service identification coincides with the detected service identification are authorized and, in the absence of BK detection, only equifrequent stations without service identification are authorized.

6. Method according to claim 5, characterized in that, when testing the receivability of the current test station, its service identification is determined and the assessment number of the equifrequent station paired with it in the coincidence test is increased if the service identification determined coincides with the permanently stored service identification of the current test station.

7. Device for carrying out the method according to one of claims 1 to 6, with a main memory (13), in which all stations in the possible radius of action of the radio receiver have been stored in coded form with station identity, broadcasting frequency, station location and station range, with an intermediate memory (14), designed as a read-write memory, for the writing at least of codes individualizing the equifrequent stations, with an arithmetic unit (17) for determining the distance between two station locations on the one hand and for the addition of the station ranges of the assigned stations on the other hand, with a comparison unit (18), which emits an output item, characterizing the coincidence, and with a subtracter (19), which determines the degree of coincidence, characterized in that, in the intermediate memory (14), each code individualizing an equifrequent station is assigned a first memory location (142) for the sum of the assessment numbers and a second memory location for the number of coincidences, in that a backing store (15), designed as a read-write memory, is provided, in which at least the frequencies of all stations which can be received at the momentary location of the radio receiver have been stored in coded form, in that the arithmetic unit (17) has connected downstream of it an assessment number calculator, preferably subtracter (19), at the output of which there is an output item characterizing the degree of coincidence of two reception areas, in that the outputs of comparison circuit (18) and assessment number calculator (19) are connected to the intermediate memory (14) in such a way that an addition of the current input item to the memory location content takes place in each of the first and second memory locations (142, 143), in that there is connected between the assessment number calculator (19) and the intermediate memory (14) a gate circuit (20), which only switches the output item of the assessment number calculator (19) through to the intermediate memory (14) as input item if the frequency of the current test station is contained in the backing store (15), in that the intermediate memory (14) has connected downstream of it a measure of assessment calculator (27), to which the memory content of the first and assigned second memory location (142, 143) is fed separately and in that the measure of assessment calculator (27) has connected downstream of it a maximum searcher (28), which emits the individualizing code of the equifrequent station to which the greatest measure of assessment belongs as identification feature for the identified station.

8. Apparatus according to claim 7, characterized in that the measure of assessment calculator has a divider (27), which divides the output item of the first memory location (142) by the output item of the second memory location (143).

9. Apparatus according to claim 7 or 8, characterised in that, in the backing store (15), each stored frequency of a receivable test station is assigned a memory location for the storage of an identity code associated with the test station, in that between gate circuit (20) and intermediate memory (14) there is connected a multiplier (22), which multiplies the output item of the assessment number calculator (19) passing the gate circuit (20) by a factor which is usually 1 and can be varied by an identification tester (25), and in that the identification tester (25) is designed in such a way that it compares for each receivable test station the identity code read out from the backing store (15) with the station identity read out from the main memory (13) and, if they coincide, generates a control signal increasing, preferably doubling, the multiplication factor of the multiplier (22) and, if they do not coincide, generates a control signal reducing, preferably inverting, the multiplication factor of the multiplier (22).

10. Apparatus according to one of claims 7 to 9, characterized by an additional receiving part (16), which constantly tests all test stations for receivability at the momentary location of the radio receiver, and by a control logic (12) which, if the test station can be received, initiates the writing of the associated broadcasting frequency to the backing store (15).

## Revendications

1) Procédé d'identification d'émetteurs radiophoniques reçus par un récepteur radiophonique notamment un auto-radio en utilisant les fréquences de réception correspondantes et des informations inscrites en mémoire concernant l'identité, la fréquence, l'emplacement et la portée de tous les émetteurs situés dans le rayon d'action de réception du récepteur-radio, et pour sélectionner des émetteurs avec une probabilité de réception élevée, on vérifie les zones de réception des émetteurs dont la fréquence d'émission correspond à la fréquence de réception, c'est-à-dire des émetteurs de fréquence équivalente, pour déterminer s'il y a recouvrement avec les zones de réception d'émetteurs de contrôle, procédé caractérisé en ce que :

- on prend comme émetteurs de contrôle tous les émetteurs mis en mémoire et, pour chaque émetteur de fréquence équivalente, on détermine le nombre des recouvrements, et pour chaque émetteur de contrôle pour lequel on a constaté un recouvrement, on vérifie la possibilité de réception à l'endroit instantané où se trouve le récepteur radiophonique et, en cas de possibilité de réception de l'émetteur de contrôle, on associe à l'émetteur de fréquence équivalente qui a été associé à l'émetteur de contrôle au cours de cette vérification de recouvrement, une valeur d'appréciation proportionnelle au degré de recouvrement des deux zones de réception, et en ce qu'on additionne toutes les valeurs d'appréciation associées à un émetteur de fréquence équivalente et on norme la somme, c'est-à-dire qu'on la divise par le nombre de recouvrements constatés pour l'émetteur équivalent et du quotient, on déduit une mesure d'appréciation de l'émetteur de fréquence équivalente et en ce que l'émetteur de fréquence équivalente dont la valeur d'appréciation est significativement supérieure à la valeur d'appréciation des autres émetteurs de fréquence équivalente, est indiqué comme émetteur identifié.

2. Procédé selon la revendication 1, caractérisé en ce que, pour un émetteur déjà identifié, on inscrit provisoirement en mémoire un code caractérisant l'identité ainsi constatée, c'est-à-dire un code d'identité en association à sa fréquence d'émission, et en ce qu'on change le nombre d'exploitation de l'émetteur de fréquence équivalente si un tel code d'identité a déjà été inscrit en mémoire pour l'émetteur de contrôle actuel.

3. Procédé selon l'une des revendications 1 et 2, caractérisé en ce qu'on constate un recouvrement des zones de réception d'un émetteur de fréquence équivalente et d'un émetteur de contrôle si la somme des portées des émetteurs est supérieure à l'éloignement des emplacements des deux émetteurs.

4. Procédé selon l'une des revendications 1 à 3, caractérisé en ce que le degré de recouvrement de deux zones de réception se calcule en soustrayant l'éloignement des emplacements de la somme des portées des émetteurs correspondants.

5. Procédé selon l'une des revendications 1 à 4, selon lequel, comme information supplémentaire, relative à l'émetteur radiophonique avec des émetteurs ARI (informations radiophoniques pour automobilistes), on inscrit en mémoire la caractéristique de domaine BK et on détecte la caractéristique de domaine d'un émetteur ARI, reçu,

- procédé caractérisé en ce que, pour la détection BK, on autorise que des émetteurs de fréquence équivalente dont la caractéristique de domaine correspond à la caractéristique de domaine détecté et en l'absence de détection BK, on n'utilise que des émetteurs de fréquence équivalente qui ne comportent pas de caractéristique de domaine.

6. Procédé selon la revendication 5, caractérisé en ce que, par le contrôle de la possibilité de réception de l'émetteur de contrôle actuel, on détermine sa caractéristique de domaine et on augmente le numéro d'exploitation de l'émetteur de fréquence équivalente qui lui a été associé lors du contrôle de recouvrement, si la caractéristique de domaine, déterminée, coïncide avec la caractéristique de domaine mise en mémoire et appartenant à l'émetteur de contrôle actuel.

7. Dispositif pour la mise en oeuvre du procédé selon l'une des revendications 1 à 6, comportant une mémoire principale (13) dans laquelle on inscrit de manière codée tous les émetteurs existant dans le rayon d'action possible du récepteur radiophonique, par leur identité d'émetteur, leur fréquence d'émetteur, l'emplacement de leur émetteur et la portée de leur émetteur, une mémoire intermédiaire (14) en forme de mémoire vive pour recevoir au moins les références individualisant les émetteurs de fréquence équivalente, comportant une unité de calcul (17) pour déterminer l'éloignement entre deux emplacements d'émetteur d'une part et pour additionner d'autre part les portées des émetteurs correspondants, une unité de comparaison (18) qui émet une donnée de sortie caractérisant le recouvrement ainsi qu'un soustracteur (19) qui détermine le degré de recouvrement, - dispositif caractérisé en ce que, dans la mémoire intermédiaire (14), à chaque caractéristique individualisant un émetteur de fréquence équivalente, on a associé un premier emplacement de mémoire (142) pour la somme des nombres d'exploitation et un second emplacement de mémoire pour le nombre de recouvrements, une mémoire arrière (15) en forme de mémoire vive, recevant au moins les fréquences de tous les émetteurs susceptibles d'être reçus à l'emplacement instantané du récepteur radiophonique, en ce que l'unité de calcul (17) est suivie par un calculateur de nombre d'exploitation, de préférence un soustracteur (19), dont la sortie fournit une durée de sortie caractérisant le degré de recouvrement de deux zones de réception, les sorties du comparateur (18) et du calculateur de nombre d'exploitation (19) étant reliées à la mémoire intermédiaire (14) de façon à effectuer, dans chacun des premier et second emplacements de mémoire (142, 143) une addition de la donnée d'entrée actuelle et du contenu de cet emplacement de mémoire, et en ce qu'entre le calculateur de nombre d'exploitation (19) et la mémoire intermédiaire (14), on a un circuit de porte (20) qui n'applique la donnée d'entrée du calculateur de nombre d'exploitation (19) à l'entrée de données et de la mémoire intermédiaire (14) que si la fréquence de l'émetteur de contrôle actuel est contenue dans la mémoire arrière (15), la mémoire intermédiaire (14) étant suivie par un calculateur de valeur d'appréciation (27) qui reçoit séparément le contenu de la mémoire du premier emplacement de mémoire (142) et du second emplacement de mémoire correspondant (143), et le calculateur de valeur d'appréciation (27) est suivi par un dispositif de recherche de maximum (28) qui émet la caractéristique d'individualisation de celui des émetteurs de fréquence équivalente qui offre la plus grande valeur d'appréciation, comme caractéristique d'identification de l'émetteur à identifier.

8. Dispositif selon la revendication 7, caractérisé en ce que le calculateur de valeur d'appréciation comporte un diviseur (27) qui divise la donnée de sortie du premier emplacement de mémoire (142) par la donnée de sortie du second emplacement de mémoire (143).

9. Dispositif selon la revendication 7 ou 8, caractérisé en ce que, dans la mémoire arrière (15), à chaque fréquence mise en mémoire appartenant à un émetteur de contrôle susceptible d'être reçu, on associe un emplacement de mémoire pour mettre en mémoire un code d'identité associé à l'émetteur de contrôle, et entre la porte (20) et la mémoire intermédiaire (14), on a un multiplicateur (22) qui multiplie la donnée de sortie traversant la porte (20) et correspondant au calculateur de nombre d'exploitation (19) par un coefficient qui est généralement égal à 1 et qui peut être modifié par un contrôleur d'identification (25), ce contrôleur (25) étant réalisé de façon que pour chaque émetteur de contrôle susceptible d'être reçu il compare le code d'identité lu dans la mémoire arrière (15) et l'identité d'émetteur lu dans la mémoire principale (13), et en cas de coïncidence, il génère un signal de commande augmentant le coefficient de multiplication du multiplicateur (22) par exemple en doublant ce coefficient et, en cas de non coïncidence, il génère un signal de commande diminuant le coefficient de multiplication du multiplicateur (22), de préférence en inversant ce signal.

10. Dispositif selon l'une des revendications 7 à 9, caractérisé par une partie complémentaire de réception (16) qui vérifie en continu tous les émetteurs de contrôle quant à la possibilité de réception à l'emplacement instantané du récepteur radio et par une logique de commande (12) qui déclenche l'inscription de la fréquence d'émetteur correspondant dans la mémoire arrière (15) lorsque l'émetteur de contrôle peut être reçu.

Empfangs- und Wiedergabeteil
BK-Decoder — 111

10
11

Anzeige — 29

Max. sucher — 28

15

Addr.
$S_{out}$
Hinter-grund-speicher
$S_{in}$

Steuerlogik

12

Addr.
Hauptspeicher
$S_{out}$

13

% — 27

16

Zusatz-empfangsteil
BK-Decoder

161

172
171
17

Reich-weiten-addierer
Ent-fernungs-rechner

14

Addr.
$S_{in}$
$S_{out}$
141

Addr.
$S_{in}$ $S_{out}$
142

Addr.
$S_{in}$ $S_{out}$
143

18
a   b
Komp.
a>b  a<b

19
a   b
△

21
Frequenz-Prüfer

25
Jdent-Prüfer

26
BK-Prüfer

20
Tor

22
×

23
×

24
×

EP 0 179 394 B1